# EUROPEAN PATENT APPLICATION

(11) **EP 2 629 158 A1**
(43) Date of publication of application: **21.08.2013**
(21) Application number: 12155696.3
(22) Date of filing: 16.02.2012
(51) Int. Cl.: G04F 5/14, G01N 24/00, G01R 33/26, H01S 1/06

(54) **Microwave resonator, quantum sensor, and atomic clock**

(71) Applicant: Université de Neuchâtel, 2000 Neuchatel (CH)
(72) Inventor: Violetti, Maddalena, 1007 Lausanne (CH); Affolderbach, Christoph, 2068 Hauterive (CH); Merli, Francesco, 1007 Lausanne (CH); Skrivervik, Anja, 1443 Champvent (CH); Mileti, Gaetano, 2000 Neuchâtel (CH)
(74) Representative: P&TS SA (AG, Ltd.)

(57) **Abstract**

A microwave resonator device for a frequency standard or sensor device is based on the frequency of an atomic or molecular quantum transition, having an interaction volume and, surrounding said volume, whereon a stack of at least one but preferably several layers of planar loop-gap structures comprising one or several flat electrodes (72) on a dielectric carrier layer (74) surrounds said volume, and an excitation structure (75) is connected to a radiofrequency device (99) for generating or detecting a radiofrequency field in said volume.

## Description

### Field of the invention

The present invention relates to the technical field of frequency standards. More specifically, the present invention relates to an atomic clock based on the hyperfine transitions of a selected atomic species, or on another suitable atomic or molecular quantum transition.

### Description of related art

Atomic clocks are used in a number of applications in which a precise timekeeping is needed, like, among others, telecommunication, localization by satellite, cell-phone networks, and others. In these devices, the clock outputs a signal that is electronically tied to the characteristic frequency of a quantum transition, thereby transferring the stability of the atomic structure to the clock rate.

Alkaline metals like Rubidium and Caesium are often employed in atomic clocks and detectors. ⁸⁷Rb, in particular, is often used and the present description will make reference to this atomic species for simplicity. The invention, however, is not limited to Rubidium vapour cells and could be used with any atomic or molecular vapour cell having suitable quantum transitions.

Atomic clocks synchronise preferably to transitions that are insensitive to magnetic field or other perturbations. In other applications, like for example atomic magnetometers, selected atomic transitions are used to measure accurately an external quantity.

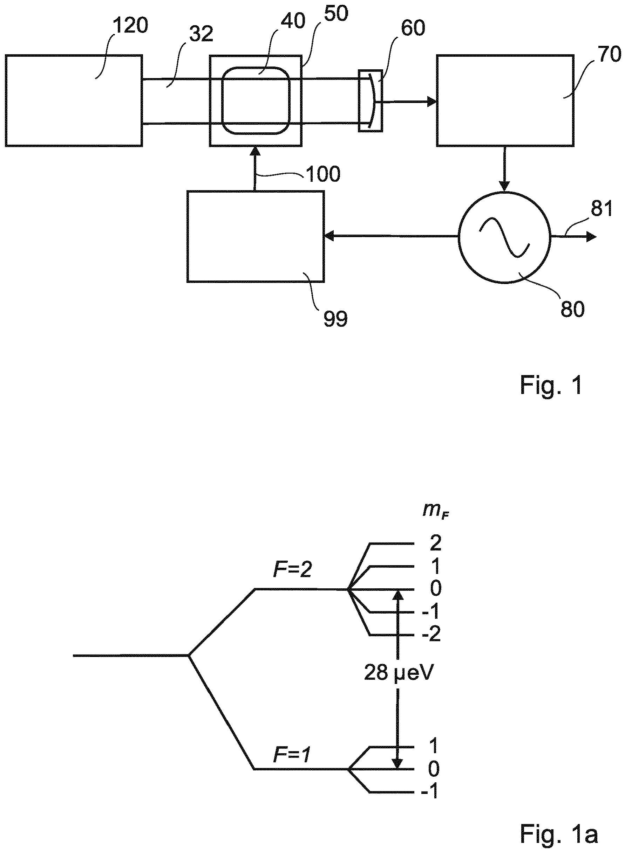

The ground state of ⁸⁷Rb is split into two hyperfine levels characterized by different total spin F=1 and F=2 (Fig. 1a). The transition between the two m_{f}=0 sublevels is insensitive to stray magnetic fields and corresponds to an energy of about 28 µeV or to a frequency ν_{hfs}=6.8347 GHz.

In a known type of atomic frequency standard, schematically represented in Fig. 1, a suitable atomic vapour, for example ⁸⁷Rb vapour, is enclosed in a sealed cell 40 placed inside a microwave cavity 50. The source 120 generates a light beam 32 having a wavelength specific to induce transitions, for example from the F=1 hyperfine state to an excited state. By the phenomenon of optical pumping, the light beam 32 creates a population imbalance between the hyperfine levels, with few atoms in the F=1 state and most atoms in the F=2 state, and the transmitted light intensity is relatively high.

The RF synthesizer 99 generates in the microwave cavity 50 a microwave field having a frequency determined by the variable oscillator 80. When the microwave frequency corresponds precisely to that of the hyperfine transition, the ground F=1 state is repopulated so that the absorption of the light beam 32 by the vapour atoms increases. The light detector 60 detects the intensity of the transmitted light and the unit 70 controls the variable oscillator 80 in order to produce the maximum absorption of light, and to lock the frequency of the oscillator 80 to the atomic transition frequency.

The quality factor of the microwave cavity and the homogeneity of the radiofrequency field in its interior are essential to the performance of the atomic standard. Conventional microwave resonators having the required properties are large and complex to produce, thus affecting negatively either the size, cost or frequency stability of known atomic frequency standards. Therefore, there is a need for a microwave resonator that can sustain a microwave frequency oscillation that is in resonance with a determined quantum transition in the vapour sample, and is smaller and cheaper to manufacture than conventional resonator cavities. There is also a need for a compact microwave resonator that has a high quality factor and that maintains a well-defined field geometry, both in terms of homogeneity of intensity and of orientation of the magnetic or electric field vectors in the volume of the vapour cell.

According to the invention, these aims are achieved by means of the object of the appended claims.

### Brief Description of the Drawings

The invention will be better understood with the aid of the description of an embodiment given by way of example and illustrated by the figures, in which:
Fig. 1 shows schematically the structure of a frequency standard or sensor device suitable for the realization of the invention.
Fig. 1a illustrates relevant quantum states of ⁸⁷Rb
Fig. 2a and 2b shows schematically two similar variants of a microwave resonator according to an aspect of the invention.
Fig. 3 shows another variant of the inventive microwave resonator.
Fig. 4 illustrates schematically an alternative structure of a frequency standard or sensor device suitable for the realization of the invention.

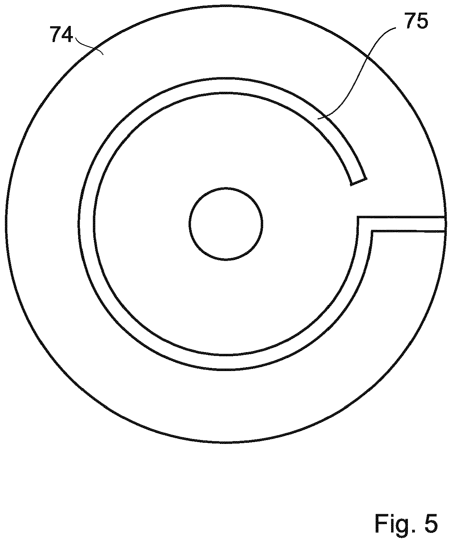

Fig. 5 illustrates schematically a possible configuration of a coupling structure of the resonance cell of the invention.
Fig. 6 shows schematically a dielectric layer with patterned electrodes according to an aspect of the present invention.

### Detailed Description of possible embodiments of the Invention

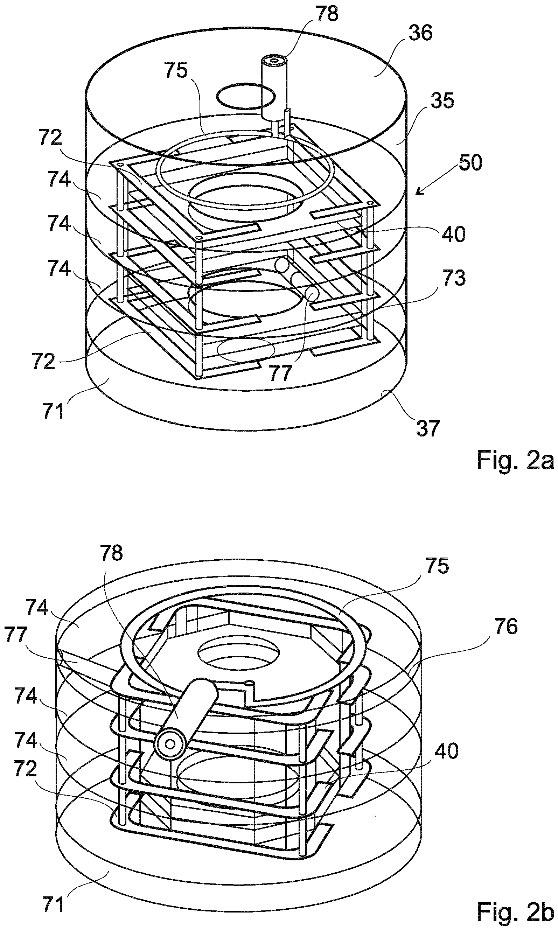

With reference to Fig. 2a, the invention relates to a microwave resonator usable in an atomic clock or in a quantum sensor. A sealed cell 40 contains a sample of atoms or molecules having a suitable quantum transition and is positioned in the inner volume of the resonator. This cell can be realized using one of several possible techniques, including glass blowing, fused glass cells, cells micro-fabricated as Si-glass stacks, or others. The resonator itself is inside a cylindrical conductive shielding 35 closed by a bottom cap 37 and by a top cap 36. The top and bottom caps have axial apertures to allow the passage of an optical beam, preferably a laser beam in resonance with an optical pump transition of the atoms or molecules in the cell 40. Preferably the openings are covered by optical windows (71) in order to achieve good temperature homogeneity in the volume enclosed by the shielding 35.

The resonator comprises a multi-layer structure of conductive electrodes 72 separated by dielectric layers 74, stacked along axial direction (z). The conductive electrodes 72 are essentially flat two-dimensional structures, preferably formed by patterning of metal films onto the dielectric layers 74 and can be realized by suitable printed-circuit board known processes, for example from metal-clad dielectrics carrier layers. The dielectric carrier composing the dielectric layers 74 has preferably a temperature-compensated dielectric constant in the microwave region. Suitable laminate materials for this application are, among others, produced by the Rogers Corporation under the R03000 (R) denomination.

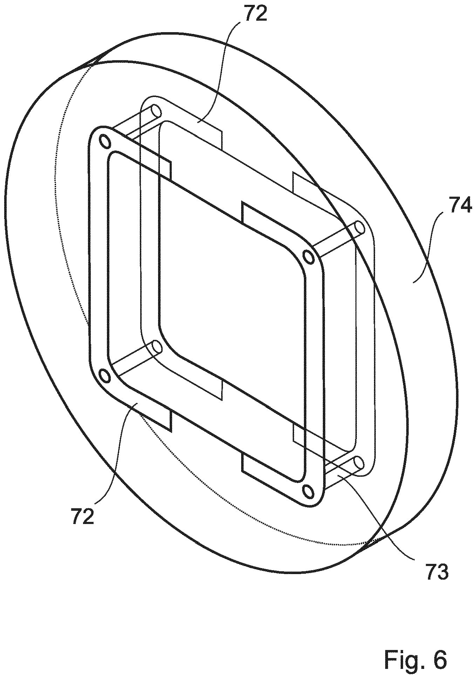

The electrodes 72 are planar realizations of loop-gap resonators. The electrodes 72 can for example be C-shaped and juxtaposed in pairs in order to obtain a series of stacked loops with gaps, where in general the loop is composed of at least one or more loop-sections, separated by one or more gaps. In the example represented in Fig. 2a+b, 4, and 6, each planar loop is composed by two planar electrodes on a dielectric layer, separated by two diameter-opposed gaps of the same width. Other shapes are however possible. The number of gaps in each loop could be different, and the loops need not be of the same width or symmetrically disposed. The shape of the electrodes and of the centre openings in the supporting substrates can be adjusted in order to adapt to different geometries of the vapour cell 40. The resonance frequency of the resonator of the invention is defined by the geometry of the electrode structure, including the dimension of the electrodes, the spacing of the gaps, the thickness and number of the dielectric layers and the number of electrodes on each layer. Advantageously, the dimensions of the resonator of the invention are sensibly smaller than the half-wavelength of the resonant microwave frequency. The electrodes 72 may or may not be in electrical contact with the shielding 35.

Preferably, the different layers of the electrode structure are connected electrically together. In the embodiment represented by the figures such connections are realized by metallised through-holes 73 (vias) traversing the dielectric layers 74. Other means of realizing the connections 73 are possible, for example by solder wicking, soldered wires or other means.

According to another, non illustrated, variant, some or all the electrodes 72 of some layers may be electrically not connected to other electrodes. Also, the electrodes 72 may be connected, or not, to the outer shield.

A fine tuning of the resonance frequency can be obtained by one or more tuning screws 77 or electrically controlled elements. In the example of Fig. 2a, a tuning screw, manually controllable, is inserted into the gap between the electrodes 72, thereby modifying the resonance frequency, other arrangement are however possible. In alternative, the tuning screw could be controlled by a suitable actuator. It would also be possible, in the frame of the invention, to tune the resonator 50 by means of varactors, controlled electrodes, or any other suitable tuning means.

Such fine tuning allows adjusting the resonator's resonance frequency for manufacturing tolerances of the resonator and the cell. Other tuning schemes, based on mobile conductive or dielectric elements are possible. A high sensitivity to tuning inputs is achieved by placing the tuning element in correspondence of the gaps between two electrodes, as illustrated. Coupling of the microwave excitation to the microwave resonator is achieved by a coupling structure placed atop or below, or close to the stack of loop-gap structures. In one embodiment, the excitation layer 76, as illustrated in Fig. 2b, comprises a loop-shaped stripline 75 patterned onto an additional layer of dielectric carrier. In alternative, the coupling structure might be arranged on one of the dielectric layers 74 that carry the electrodes 72.

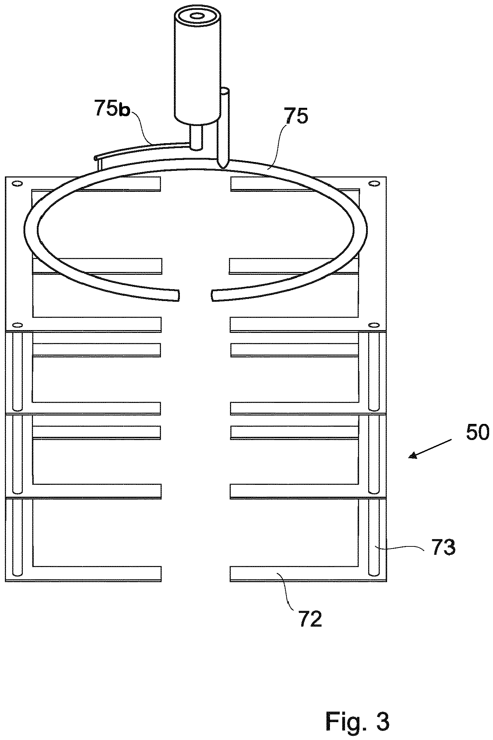

In a variant embodiment, represented schematically in fig 3, the coupling structure consists of a half-wave loop (HALO) 75b stripline which might be metallised onto an additional layer of dielectric carrier 76 or directly on any other layer of the electrode stack.

Optionally, additional layers 76 of dielectric can be stacked between the stack of loop-gap structures and the coupling structure in order to control the quality of coupling. Feeding of microwave energy can be obtained by a coaxial line or strip line soldered to the coupling structure. Additional layers 71 of dielectrics can also be stacked between the stack of loop-gap structures and the bottom cap 37 or the top cap 36, to improve on the properties of the microwave field inside the resonator.

Advantageously, the resonator of the invention can be produced by industrial microwave PCB processes that allow large-scale parallel production at low cost and with excellent tolerances and reproducibility, in contrast with traditional resonators, that must be machined individually.

There is a general agreement that adhesives are a source of unreliability, and their aging is not fully understood. Preferably, the laminated loop-gap electrodes 72 on the respective substrates 74, the coupling structure 75 and 76 and the vapour cell 40 have shapes and dimension that allow stacking them inside the shielding 35 in a precise and repeatable position without the use of adhesives. Precise alignment between the different substrate layers can also be achieved by assembling the layers on an auxiliary precision pre-form support having the same geometry as the vapour cell. If necessary, spacer layers 71 having the required thickness and dielectric constant can be inserted inside the outer shield. These spacers could be continuous disks made of a suitable optical material in order to achieve a homogeneous temperature distribution around the vapour cell 40 while maintaining optical access for the laser beam 32.

The resonator 50 of the invention as above described can usefully be used in a frequency standard or quantum sensor having the general structure represented in Fig. 1 in which the resonator 50 of the invention contains a vapour cell 40 enclosing ⁸⁷Rb vapour, or any other suitable atomic or molecular vapour. The light source 120 generates an optical beam having the required wavelength to pump the atoms or molecules of the vapour, while the photodetector 60 placed on the path of the optical beam 32 after the cell 40 drives the control circuit 70, 80 driving the radiofrequency source 99 so as to lock the frequency of the radiofrequency source 99 to the atomic or molecular transition frequency.

Advantageously, the vapour cell 40 could contain a sample of cold atoms or molecules or ions produced e.g. by laser cooling. As a result, the precision of the device is improved.

According to another embodiment, the resonator 50 described above is used to realize an active, maser-like frequency standard. The interaction volume contains an atomic or molecular sample that is prepared, either optically, magnetically, or by any other suitable means, such to emit electromagnetic radiation at a selected quantum transition frequency. The radiation is then collected by the resonator 50 and its coupling structure 75, and a suitable radiofrequency detector and control circuits are used to steer the clock output to the detected transition frequency.

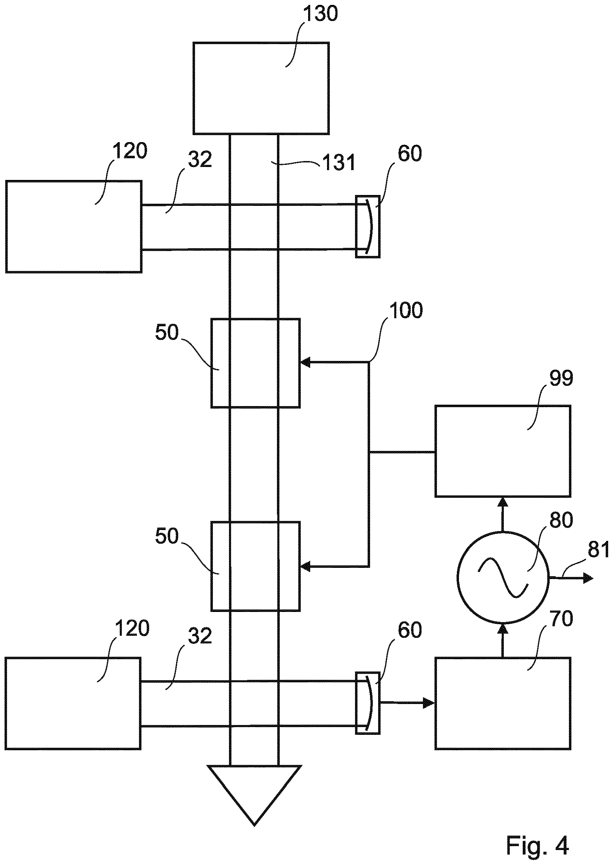

In an alternative embodiment of the invention, one or more of the inventive resonators 50 are used in a frequency standard or quantum sensor that does not involve a sealed vapour cell, but rather a directed beam 131 of atoms or molecules exhibiting the quantum transition frequency. In this case, suitable openings in the substrate layers (71, 74, 76) are foreseen. In the variant represented schematically in Fig. 4 two microwave resonators 50 separated in space are traversed by the same atomic or molecular beam 131, and a controlled microwave source 99 is connected to the excitation structures 75 in the respective resonators. Two optical beams 32, generated by two sources 120 are used above and below the resonators 50 to prepare the beam 131 and, respectively, to detect the quantum transitions. The optical signal measured by photodetector 60 relates to the match between the frequency generated by the radiofrequency source 99 and the quantum transition frequency, and can be used to lock the frequency of the radiofrequency source (99) to the atomic or molecular transition frequency.

In a variant of this embodiment, an additional dielectric layer equipped with a strip-line microwave feed is employed to precisely position in space the two microwave resonators 50 and to appropriately couple the microwave signal 100 to the two resonators' microwave terminals preserving a precise phase relationship.

The above embodiments allow several variants that, even if they are not illustrated and discussed in full detail, are comprised in the scope of the appended claims. In particular, preparation of the initial state and detection could be carried out by non-optical methods. The atom or molecule beam 131 could be folded in order to pass twice in the same resonator 50, rather than in two distinct resonators. Furthermore, a resonator as above described could include, instead of the sealed vapour cell 40, a trap into which a sample of trapped ions, atoms, or molecules is confined, for example electrostatically, magnetically, optically, or by any suitable confinement technique.

### Reference numbers used in the figures

- 32: light beam
- 35: outer shield
- 36: top cap
- 37: bottom cap
- 40: vapour cell
- 50: microwave resonator
- 60: photodetector
- 70: detection unit, lock-in amplifier
- 71: Additional dielectric substrate(s) or glass optical spacer(s)
- 72: patterned electrode
- 73: via
- 74: substrate
- 75: excitation or coupling structure
- 75b: Half-wave loop
- 76: coupling layer
- 77: tuning screws or tuning elements
- 78: microwave terminal
- 80: local oscillator
- 81: clock output
- 99: microwave synthesizer
- 100: microwave signal
- 120: light source
- 130: Atomic or molecular beam source
- 131: Atomic or molecular beam

## Claims

1. A microwave resonator device for a frequency standard or sensor device based on the frequency of an atomic or molecular quantum transition, having an interaction volume and, surrounding said interaction volume, at least one loop-gap structure comprising one or several flat electrodes (72) on one or several carrier layers (74) made of a dielectric or isolating material, surrounding said volume, and a coupling structure (75) connectable to a radiofrequency device (99) for generating or detecting a radiofrequency field in said interaction volume.

2. The device of the preceding claim, having a multi-layer structure including a plurality of dielectric layers (74), superposed along an axial direction (z), conductive flat electrodes (72) affixed on or inserted between said layers, arranged to provide a stack of loop-gap structures.

3. The device of the preceding claim, wherein at least some flat electrodes (72) are connected electrically with one another.

4. The device of the preceding claim, wherein at least some flat electrodes (72) are connected electrically with other axially adjacent flat electrodes by axial vias (73) traversing said dielectric layers (74).

5. The device of any of claims 1 or 2, wherein at least some flat electrodes (72) are not electrically connected with other flat electrodes (72).

6. The device of any of the preceding claims, where one or several of the flat electrodes (72) are electrically isolated from an outer shield (35).

7. The device of any of the preceding claims, where one or several of the flat electrodes (72) are electrically connected to an outer shield (35).

8. The device of any of the preceding claims, wherein the coupling structure is integrated on one or several carrier layers (74) or is contained in a separate coupling layer (76) and wherein the coupling structure includes a planar electrode structure fed by a coaxial line or by a stripline.

9. The device of any of claims 6-7, wherein the planar electrode structure comprises a conductive loop (75) or a half-wave loop (75b).

10. The device of any of the preceding claims, wherein the microwave resonator has a controllable tuning element (77).

11. A frequency standard or sensor device based on the frequency of an atomic or molecular quantum transition, including at least one microwave resonator (50) of any of the preceding claims.

12. The device of the previous claim, wherein the microwave resonator (50) encloses a cell (40) holding atoms, ions, or molecules exhibiting the quantum transition frequency.

13. The device of claim 11, wherein one or several of the microwave resonators (50) are traversed by a beam (131) of atoms, ions, or molecules exhibiting the quantum transition frequency.

14. The device of the any of claims 11 to 13, wherein the cell (40) or the beam (131) of atoms, ions, or molecules are traversed by an optical beam (32).

15. The device of the preceding claim, further including a light source (120) generating said optical beam, a photodetector (60) placed on the path of the optical beam (32) after the cell (40) and a control circuit (70, 80) driving the radiofrequency source (99) based on the output of the photodetector (60) so as to lock the frequency of the radiofrequency source (99) to the atomic or molecular transition frequency.

16. The device of any of the claims 12 to 14, further including a light source (120) generating an optical beam (32), wherein the atoms, ions, or molecules exhibiting the quantum transition frequency are prepared such to emit electromagnetic radiation at that quantum transition frequency, and a radiofrequency detector coupled to the coupling structure, and a control circuit driving an oscillator so as to lock the frequency of the oscillator to the quantum transition frequency.
